Europäisches Patentamt

(19) **European Patent Office**

Office européen des brevets

(11) Numéro de publication: **0 227 692**
**B1**

(12) **FASCICULE DE BREVET EUROPEEN**

(45) Date de publication du fascicule du brevet: 25.07.90

(51) Int. Cl.⁵: **C 30 B 25/02,** C 03 C 17/22, C 23 C 16/30

(21) Numéro de dépôt: 86901918.2

(22) Date de dépôt: 02.04.86

(86) Numéro de dépôt international:
PCT/FR86/00113

(87) Numéro de publication internationale:
**WO 86/05824 09.10.86 Gazette 86/22**

(54) **COUCHE MINCE A BASE D'UN SEL DE RUTHENIUM.**

(30) Priorité: 02.04.85 FR 8504982

(43) Date de publication de la demande:
08.07.87 Bulletin 87/28

(45) Mention de la délivrance du brevet:
25.07.90 Bulletin 90/30

(84) Etats contractants désignés:
AT BE CH DE FR GB IT LI LU NL SE

(56) Documents cités:
chemical Abstracts, vol. 99, no. 2, 11 juillet 1983, Columbus, Ohio (US); H.M. Kuehne et al.:"Iron-doped ruthenium disulfide electrodes", p. 436, résumé 12668f

Chemical Abstracts, vol. 100, no. 20, 14 mai 1984, Columbus, Ohio (US); R. Bichsel et al.:"Growth and physical properties of ruthenium sulfide single crystals", p. 605, résumé 166019w

(73) Titulaire: **CENTRE NATIONAL DE LA RECHERCHE SCIENTIFIQUE (CNRS)**
**15, Quai Anatole France**
**F-75007 Paris (FR)**

(72) Inventeur: **GOROCHOV, Ouri**
**11 bis, rue Georges Sand**
**F-91320 Wissous (FR)**
Inventeur: **EZZAOUIA, Hatem Laboratoire de Physique des**
**Solides CNRS 1, Place Aristide Briand**
**F-92195 Meudon Principal Cedex (FR)**

(74) Mandataire: **Tonnellier, Jean-Claude et al**
**Cabinet Nony & Cie. 29, rue Cambacérès**
**F-75008 Paris (FR)**

Courier Press, Leamington Spa, England.

# EP 0 227 692 B1

**Description**

La présente invention a pour objet une couche mince à base d'un sel de ruthénium, sa préparation et son application.

On sait que l'industrie utilise de plus en plus des matériaux divers, et notamment des matériaux semi-conducteurs, sous la forme de couches minces, en vue de réaliser certains dispositifs ou composants électroniques, tels que des capteurs optiques, des capteurs de pression, des photorésistance, des photopiles etc.

Dans la recherche de nouveaux matériaux semi-conducteurs, l'attention s'est portée récemment sur des dérivés de ruthénium et, en particulier, le sulfure de ruthénium qui est un matériau ayant des propriétés exceptionnelles.

Le sulfure de ruthénium est en effet le seul composé semi-conducteur, à part quelques oxydes à grand gap, à être stable en milieu aqueux et exposé à la lumière, alors même que le milieu ne contient aucun couple redox spécifique d'une stabilisation.

On a récemment préparé des monocristaux de sulfure de ruthénium synthétisés par une technique particulière utilisant un bain de tellure. Les monocristaux obtenus ont diverses propriétés, notamment des propriétés mécaniques intéressantes; en particulier, ces cristaux sont plus durs que la silice. Voir H. EZZAOUIA et al., J. Electroanal. Chem., 145 (1983), 279—292.

Le sulfure de ruthénium possède également une résistance exceptionnelle aux agents chimiques et physiques puisqu'il est stable dans l'eau régale à l'ébullition, sous un éclairement intense, en présence d'oxygène, etc. Les couches minces de l'invention peuvent donc servir en outre à réaliser des dépôts de protection.

L'obtention de couches minces à base de sulfure de ruthénium pose des problèmes difficiles car il s'agit d'un matériau réfractaire. Il n'est donc pas possible d'opérer par condensation de vapeurs de ce composé.

Parmi les techniques de réalisation de couches minces de semi-conducteurs, la technique de déposition réactive en phase gazeuse à partir d'un composé organométallique, technique souvent désignée par le sigle CVD-OM (Chemical Vapor Deposition-Organometallic) ou MOCVD (Metallo Organic Chemical Vapor Deposition) a pris un essor important des dernières années. Voir par exemple l'article de H. M. MANASEVIT, Journal of Crystal Growth, 55 (1981), 1—9.

Cette technique de co-déposition réactive d'espèces gazeuses sur la surface d'un substrat chauffé consiste généralement à entraîner par un gaz vecteur inerte les vapeurs d'un dérivé organométallique liquide d'un métal et d'un composé réactif gazeux capable de transformer ledit dérivé organométallique en sel du métal. Au contact du substrat chauffé, la réaction entre les deux espèces gazeuses se produit avec formation du sel métallique solide qui se dépose sur le substrat. On peut ainsi réaliser des dépôts de couches minces sur le substrat.

Dans le cas du ruthénium, les dérivés organométalliques alkylés ne sont pas commercialisés couramment. On a découvert toutefois que l'utilisation de dérivés organométalliques solides du ruthénium ayant une tension de vapeur suffisante permet de mettre en ouevre la technique de déposition réactive en phase gazeuse, et d'obtenir des couches minces qui peuvent être, selon les cas, soit des couches polycristallines ou amorphes, soit des couches monocristallines épitaxiées. La structure de ces couches minces peut être révélée par l'étude de la diffraction des rayons X.

La présente invention a pour objet une couche mince déposée sur un substrat solide, caractérisée par le fait que ladite couche mince est constituée essentiellement d'un composé de formule $RuX_{2\pm x}Z_y$ (appelé ci-après composé de formule (I) dans laquelle X représente au moins un élément choisi parmi le soufre, le sélénium et le tellure, x est un nombre, y compris zéro, inférieur ou égal à 0,02, représentant l'écart à la stoechiométrie, Z est un agent dopant, éventuellement introduit, et y est le nombre d'atomes d'agent dopant par atome de ruthénium.

Autrement dit, la couche mince du dispositif de l'invention peut être constituée par le composé $RuX_{2\pm x}$ (sulfure de ruthénium, séléniure de ruthénium, tellurure de ruthénium ou leurs mélanges) ou encore par des mélanges du type $RuX_{(2\pm x)}Z_y$, Z étant un agent dopant, x et y étant définis comme précédemment (avec y différent de zéro).

Le substrat sur lequel est déposée la couche mince à base de dérivés de ruthénium peut être soit un isolant, soit un semi-conducteur, soit un conducteur.

Lorsque le substrat est un isolant, par exemple un verre isolant tel qu'un verre de silice, le dispositif obtenu peut être utilisé comme fenêtre optique ou encore comme photorésistance.

Avec un substrat de verre, la couche mince est généralement sous la forme d'une couche polycristalline ou amorphe.

Lorsque le substrat est un semi-conducteur, la couche mince à base de dérivés de ruthénium déposée peut servir par exemple de couche protectrice, ou de fenêtre optique. Bien entendu, le substrat de semi-conducteur (silicium, arséniure de gallium) peut être utilisé par exemple comme substrat isolant ou semi-isolant, s'il est suffisamment pur, et dans ce cas le dispositif de l'invention permettra d'utiliser les propriétés de semi-conducteur propres à la couche mince de dérivé de ruthénium.

Lorsque le substrat est un monocristal qui possède des paramètres de réseau en accord avec ceux du cristal $RuX_2$, il est possible d'obtenir une couche mince monocristalline épitaxiée. C'est le cas par exemple

2

lorsque le substrat est un cristal d'arséniure de gallium, qui est un semi-conducteur connu.

En effet, l'arséniure de gallium a un paramètre de réseau en bon accord avec celui du cristal de sulfure de ruthénium. Il est donc possible de déposer sur l'arséniure de gallium une couche mince monocristalline de sulfure de ruthénium par croissance épitaxique.

Il en résulte la possibilité de réaliser un grand nombre de dispositifs qui associent le substrat arséniure de gallium (conducteur ou semi-isolant) et la couche de $RuX_2$.

Dans le cas d'un substrat conducteur, la couche mince selon l'invention peut être utilisée par exemple dans la réalisation de cellules photoélectriques, de composants électroniques etc.

Avec un substrat métallique, on peut réaliser par exemple des électrodes pour réactions photoélectrochimiques.

L'invention concerne également l'utilisation de la couche mince selon l'invention comme revêtement de protection du substrat. Un tel revêtement permet d'obtenir une protection par passivation ou encore d'obtenir, en raison des propriétés de résistance mécanique, chimique et thermique du sel $RuX_2$, un effet de protection contre l'usure mécanique, contre la corrosion, contre les chocs thermiques, etc.

La couche mince selon l'invention est une couche d'épaisseur égale à quelques dizaines de micromètres, généralement inférieure à 20 micromètres, et englobe une couche monoatomique et les fractions de couche monoatomique.

De telles couches monoatomiques, complètes ou partielles, peuvent être utilisées en particulier pour réaliser des catalyseurs.

Dans les dispositifs utilisant le composé $RuX_2$ comme semi-conducteur, l'épaisseur de la couche mince est le plus souvent inférieure ou égale à 3 micromètres environ, et généralement supérieure à $10^{-8}$ m.

L'agent dopant peut éventuellement être introduit afin d'augmenter, si désiré, la conductivité de la couche mince de semi-conducteur. Le choix d'agents dopants appropriés permet d'obtenir, comme cela est connu des spécialistes, des couches minces de conductivité de type p ou n. La proportion d'agent dopant volontairement introduit est fonction d'une part de la conductivité optimale recherchée, qui peut varier selon l'application envisagée, et d'autre par, de la proportion d'impuretés introduites du fait même de la méthode de fabrication utilisée (pureté des produits de départ, appareillage etc.). La proportion d'agent dopant dans les composés de formule (I) est généralement de l'ordre de $10^{-2}$ à $10^{-8}$ atomes par atome de ruthénium.

Il est évident pour les spécialistes que l'agent dopant peut être tout élément autre que le ruthénium.

Bien entendu, dans le cas de l'utilisation de la couche mince comme revêtement protecteur, les exigences de pureté du sel $RuX_2$ sont moins contraignantes que dans le cas de l'utilisation en tant que semi-conducteur.

La présente invention a également pour objet un procédé de préparation d'une couche mince telle que définie précédemment.

Ce procédé est principalement caractérisé par le fait que l'on porte le substrat à une température de 200 à 1000°C environ, que l'on amène au voisinage du substrat, à l'aide d'un courant de gaz vecteur, un mélange de vapeurs d'un composé organo-métallique du ruthénium et de vapeurs d'au moins un composé $XH_2$, X étant défini comme précédemment, les débits des réactifs gazeux étant réglés de façon à correspondre aux proportions respectives des éléments Ru et X dans le composé que l'on veut obtenir sous forme de couche mince déposée sur le substrat, et qu'on introduit en outre, si désiré, selon les méthodes connues, un agent dopant dans ladite couche mince.

Parmi les composés organo-métalliques du ruthénium, on citera plus particulièrement le ruthénocène qui est un composé très stable à l'air ou en présence $H_2S$ à température ambiante ou inférieure à 200°C.

Le ruthénocène est un solide ayant un point de fusion de l'ordre de 194—198°C et qui possède une tension de vapeur suffisante pour être utilisable comme source de ruthénium dans un procédé mettant en oeuvre la méthode CVD-OM.

Les vapeurs de ruthénocène peuvent être entraînées par contact avec un courant de gaz vecteur.

Pour obtenir le dépôt d'une couche mince sous la forme d'une couche mono-cristalline, par croissance épitaxique, il convient d'utiliser un substrat mon-cristallin et de procéder au dépôt de la couche mince sur le substrat chauffé à une température ne dépassant pas 650°C environ, et en particulier à une température de 200 à 650°C environ, généralement de 300 à 600°C environ.

Lorsque l'on ne désire pas obtenir une couche mince mono-cristalline, et en particulier lorsque le substrat est un substrat vitreux, on peut opérer généralement avec un substrat chauffé à une température de 450 à 900°C environ.

Lorsque le substrat est métallique, on opère par exemple à une température de 300 à 900°C.

Bien entendu, le substrat est réalisé en un matériau inerte vis à vis des réactifs, ou ne réagissant que lentement avec le gaz $XH_2$ à la température réactionnelle.

Généralement, on opère à la pression atmosphérique, ou sous une pression voisine de la pression atmosphérique.

Le gaz vecteur peut être un gaz inerte, par exemple l'argon. On utilise le plus souvent comme gaz vecteur un mélange de gaz inerte et d'hydrogène, dont les proportions ne sont généralement pas critiques et peuvent être déterminées dans chaque cas, si nécessaire, par de simples expériences de routine, comme cela est connu des spécialistes. L'utilisation d'une atmosphère réductrice permet d'éviter l'inclusion dans la couche mince de carbone provenant de la décomposition du dérivé organométallique à la température réactionnelle.

L'utilisation d'hydrogène pur ne convient généralement pas car le composé $RuX_2$ risque alors d'être lui-même réduit.

Pour obtenir une couche mince présentant un écart à la stoechiométrie par rapport au composé $RuX_2$, il suffit d'augmenter ou de diminuer légèrement le débit du composé $XH_2$.

Pour introduire l'agent dopant Z, on peut opérer par CVD-OM, par exemple à l'aide d'une source autre que la source de ruthénocène et qui sera adjointe au montage.

Dans le cas où l'agent dopant est un métal, on peut le déposer en utilisant une source dudit métal, par exemple un dérivé organométallique, dont les vapeurs sont entraînées par le gaz vecteur.

Dans le cas où l'agent dopant est un métalloïde, on peut utiliser comme source tout dérivé convenable du métalloïde ayant une pression de vapeur suffisante, par exemple un hydrure tel que l'arsine.

Les spécialistes comprendront que l'écart à la stoechiométrie est équivalent à un dopage du semi-conducteur. D'une façon générale, les proportions d'agent dopant sont évaluées par la mesure des propriétés électroniques (conductivité; mobilité des porteurs). Ces mesures peuvent être complétées, si désiré, par des analyses qualitatives à l'aide des techniques modernes de haute précision.

Le type de conductivité obtenu (p ou n) peut être déterminé par l'étude de l'effet HALL.

L'invention a également pour objet l'utilisation d'une couche mince, telle que définie précédemment, dans la réalisation de tous montages ou composantes à semi-conducteur, d'électrodes pour photoélectrolyse, ou de catalyseurs, en particulier de catalyseurs de désulfuration d'hydrogénation ou d'oxydation, en encore comme revêtement de protection.

Les couches minces telles que définies précédemment peuvent constituer notamment des dépôts de protection, des filtres optiques, des dépôts de passivation sur semi-conducteur ou sur métal, des catalyseurs etc.

Les exemples suivants illustrent l'invention sans toutefois la limiter.

Exemples de réalisation de couches minces

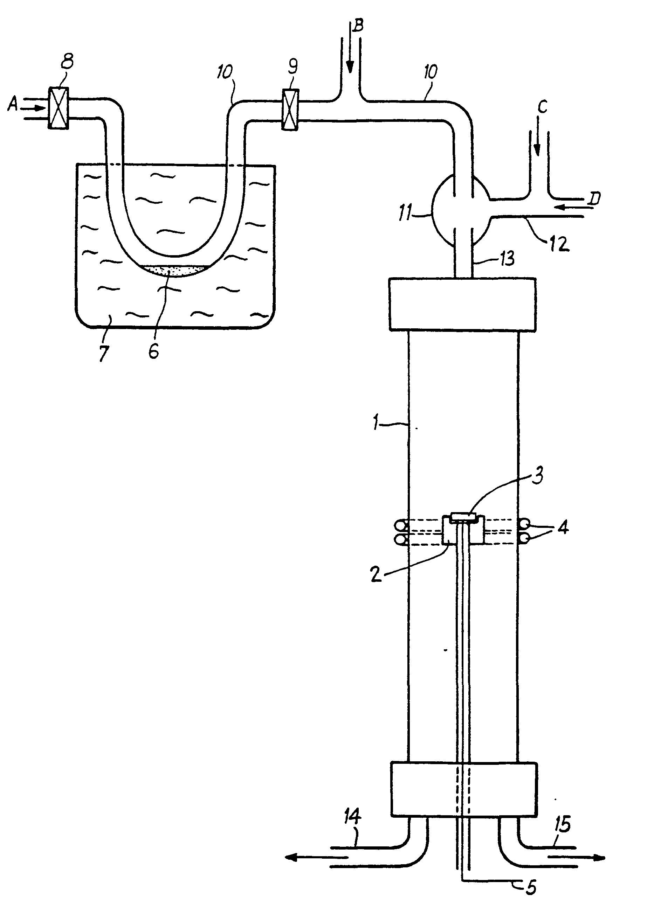

On fait référence à la figure 1 qui représente schématiquement l'appareillage utilisé.

Cet appareillage comporte un réacteur vertical (1) en silice avec un support approprié (2), par exemple en graphite, sur lequel est placé le substrat (3).

Le support muni du substrat est porté à la température réactionnelle choisie à l'aide d'un élément chauffant à induction schématisé par les spires (4). Le thermocouple (5) permet de contrôler la température.

Une source (6) de ruthénocène est maintenue à température constante à l'aide d'un thermostat (7).

Les sources A, B et C sont alimentées par un mélange gazeux contenant 75% d'argon et 25% d'hydrogène.

Le mélange argon-hydrogène de qualité dite U, est commercialisé par la société L'AIR LIQUIDE.

Après introduction du substrat (3), on ouvre les robinets des sources B et C et on fixe un débit déterminé du mélange gazeux.

On ouvre alors les robinets des sources A et D et on règle les débits gazeux du mélange argon-hydrogène (source A) et de $H_2S$ (source D).

Les contrôles les débits gazeux sont effectués par des débitmètres à bille (non représentés) et des vannes à aiguilles telles que 8 et 9.

On fixe ensuite la température du substrat en réglant le courant d'induction dans les spires (4).

Le courant gazeux provenant de la source A, par contact avec la source de ruthénocène (6), entraîne des vapeurs de ruthénocène par le conduit 10 qui débouche verticalement dans l'ampoule (11) communiquant avec la partie supérieure du réacteur (1).

Le gaz $H_2S$ provenant de la source D, dilué par le gaz en provenance de la source C, circule dans le conduit (12) qui débouche horizontalement dans l'ampoule (11), ce qui assure l'obtention d'un mélange homogène avec les gaz provenant du conduit (10).

Le mélange gazeux passe dans le réacteur (1) via le conduit (13) situé à la partie supérieure du réacteur. Au contact du substrat chauffé (3), le gaz $H_2S$ réagit avec le ruthénocène pour donner un dépôt de sulfure de ruthénium tandis que les produits résultant des réactions de décomposition du ruthénocène avec l'hydrogène sont entraînés vers le bas du réacteur et évacués par les conduits (14, 15).

Tous les conduits sont en acier inoxydable résistant à $H_2S$.

Après un temps de déposition pouvant aller de quelques minutes à quelques heures selon l'épaisseur désirée pour la couche mince, on arrête l'expérience on opérant de la façon suivante:
— arrêt du chauffage;
— fermeture des sources A et D;
— puis, après refroidissement du substrat à température inférieure à 100°C;
— fermeture des sources B et C;
— on maintient ensuite un débit d'argon pur dans le conduit de l'$H_2S$ pour purger le réacteur pendant 10 minutes à plusieurs heures;
— enfin, on extrait l'échantillon.

A titre d'illustration, on a reproduit dans le tableau I qui suit les résultats obtenus en faisant varier certaines conditions expérimentales.

| Ex. | Substrat | Temperature substrat | Duree (minutes) | Temperature (°C) | Debit $H_2S$ (cm³/min.) | Debit Source A (cm³/min.) | Debit Source C (cm³/min.) | Debit Source B (cm³/min.) | Epaisseur de la couche deposée (micromètres) |
|---|---|---|---|---|---|---|---|---|---|
| 1 | SiO₂ | 654 | 75 | 94 | 20 | 40 | 60 | 60 | 0,5* |
| 2 | SiO₂ | 764 | 90 | 94 | 20 | 40 | 60 | 60 | 1,2* |
| 3 | SiO₂ | 614 | 120 | 112 | 46 | 35 | 135 | 250 | 3,06* |
| 4 | SiO₂ | 614 | 15 | 112 | 46 | 35 | 135 | 250 | 1,9* |
| 5 | SiO₂ | 614 | 60 | 112 | 38 | 35 | 50 | 50 | 2,6* |
| 6 | SiO₂ | 614 | 40 | 112 | 38 | 35 | 50 | 50 | 1,8* |
| 7 | SiO₂ | 614 | 15 | 112 | 38 | 35 | 50 | 50 | 1,25* |
| 8 | SiO₂ | 614 | 7 | 112 | 38 | 35 | 50 | 50 | 0,95* |
| 9 | GaAs | 614 | 90 | 112 | 20 | 35 | 65 | 65 | 1,5** |
| 10 | GaAs | 500 | 60 | 112 | 55 | 35 | 50 | 50 | 0,45** |
| 11 | GaAs | 400 | 60 | 112 | 55 | 40 | 50 | 50 | 0,13** |

* Couche polycristalline
** Couche épitaxiée

# EP 0 227 692 B1

**Revendications**

1. Couche mince déposée sur un substrat solide caractérisée par le fait que ladite couche mince est constituée essentiellement d'un composé de formule $RuX_{2\pm x}Z_y$ dans laquelle X représente au moins un élément choisi parmi le soufre, le sélénium et le tellure, x est un nombre inférieur ou égal à 0,02, représentant l'écart à la stoechiométrie, Z est un agent dopant, éventullement introduit, et y est le nombre d'atomes d'agent dopant par atome de ruthénium.

2. Couche mince selon la revendication 1, caractérisée par le fait que ledit agent dopant est présent à raison de $10^{-2}$ à $10^{-8}$ atomes par atome de ruthénium.

3. Couche mince selon l'une quelconque des revendications précédentes, caractérisée par le fait que ledit substrat est un isolant et en particulier un verre tel qu'un verre de silice.

4. Couche mince selon l'une quelconque des revendications 1 et 2, caractérisée par le fait que ledit substrat est un semi-conducteur.

5. Couche mince selon l'une quelconque des revendications 1 et 2, caractérisée par le fait que ledit substrat est un conducteur, en particulier un métal.

6. Couche mince selon l'une quelconque des revendications précédentes, caractérisée par le fait que ladite couche mince est constituée de sulfure de ruthénium.

7. Couche mince selon l'une quelconque des revendications 1, 2 et 4 à 6, caractérisée par le fait que ledit substrat est un cristal possédant des paramètres de réseaux en accord avec ceux du cristal $RuX_2$, et que ladite couche mince est une couche mono-cristalline obtenue par croissance épitaxique.

8. Couche mince selon la revendication 7, caractérisée par le fait que ledit substrat est un cristal d'arséniure de gallium.

9. Procédé de préparation d'une couche mince telle que que définie dans l'une quelconque des revendications précédentes, principalement caractérisé par le fait que l'on porte le substrat (3) à une température de 200 à 1000°C environ, que l'on amène au voisinage du substrat, à l'aide d'un courant de gaz vecteur (A, C), un mélange de vapeurs d'un composé organo-métallique du ruthénium (6) et de vapeurs (D) d'un composé $XH_2$, X étant défini comme précédemment, les débits des réactifs gazeux étant réglés de façon à correspondre aux proportions respectives des éléments Ru et X dans le composé que l'on veut obtenir sous forme de couche mince déposée sur le substrat, et qu'on introduit en outre, si désiré, selon les méthodes connues, un agent dopant dans ladite couche mince.

10. Procédé selon la revendication 9, caractérisé par le fait que le composé organo-métallique de ruthénium est le ruthénocène.

11. Procédé selon la revendication 9 ou 10, caractérisé par le fait que ledit gaz vecteur est un gaz inerte ou un mélange de gaz inerte et d'hydrogène.

12. Procédé selon l'une quelconque des revendications 9 à 11, caractérisé par le fait que ledit substrat est un monocristal et qu'il est chauffé à une température de 200 à 650°C environ.

13. Procédé selon l'une quelconque des revendications 9 à 11, caractérisé par le fait que ledit substrat est un verre et qu'il est chauffé à une température de 450 à 900°C environ.

14. Utilisation d'une couche mince telle que définie dans l'une quelconque des revendications 1 à 8, dans la réalisation de montages ou composants à semi-conducteurs, de photoélectrodes ou de catalyseurs, ou comme revêtement de protection.

**Patentansprüche**

1. Auf einem festen Substrat aufgetragene Dünnschicht, dadurch gekennzeichnet, daß sie im wesentlichen aus einer Verbindung der Formel $RuX_{2\pm x}Z_y$ besteht, wobei X mindestens eines der Elemente Schwefel, Selen und Tellur bedeutet, x eine Zahl kleiner oder gleich 0,02 ist und die Abweichung von der Stöchiometrie darstellt, Z ein gegebenenfalls eingebrachter Dotiertstoff ist und y die Anzahl an Störstoffatomen pro Rutheniumatom angibt.

2. Dünnschicht nach Anspruch 1, dadurch gekennzeichnet, daß der Dotierstoff im Verhältnis von $10^{-2}$ bis $10^{-8}$ Atomen pro Rutheniumatom vorliegt.

3. Dünnschicht nach einem der vorherigen Ansprüche, dadurch gekennzeichnet, daß das Substrat isolierend, insbesondere ein Glas wie etwa Silicatglas, ist.

4. Dünnschicht nach Anspruch 1 oder 2, dadurch gekennzeichnet, daß das Substrat ein Halbleiter ist.

5. Dünnschicht nach Anspruch 1 oder 2, dadurch gekennzeichnet, daß das Substrat ein Leiter, insbesondere ein Metall, ist.

6. Dünnschicht nach einem der vorherigen Ansprüche, dadurch gekennzeichnet, daß sie aus Rutheniumsulfid besteht.

7. Dünnschicht nach einem der Ansprüche 1, 2 und 4 bis 6, dadurch gekennzeichnet, daß das Substrat ein Kristall mit Gitterparametern entsprechend denen des $RuX_2$-Kristalls ist, und daß die Dünnschicht eine durch epitaxiales Wachstum erhaltene einkristalline Schicht ist.

8. Dünnschicht nach Anspruch 7, dadurch gekennzeichnet, daß das Substrat ein Galliumarsenid-Kristall ist.

9. Verfahren zur Herstellung einer Dünnschicht nach einem der vorhergehenden Ansprüche, in erster Linie dadurch gekennzeichnet, daß das Substrat (3) auf eine Temperatur von etwa 200 bis etwa 1000°C

6

gebracht; mit Hilfe eines Trägergasstroms (A, C) eine Mischung von Dämpfen einer Organometallverbindung (6) des Rutheniums und Dämpfen (D) der Verbindung XH₂ zugeführt wird, wobei X wie oben definiert ist und die Mengen der gasförmigen Reaktionsteilnehmer derart reguliert werden, daß sie den jeweiligen Proportionen der Elemente Ru und X in der Verbindung entsprechen, die in Form der auf dem Substrat aufgetragenen Dünnschicht erhalten werden soll; und außerdem gegebenenfalls ein Dotierstoff nach bekannten Verfahren in die Dünnschicht eingebracht wird.

10. Verfahren nach Anspruch 9, dadurch gekennzeichnet, daß die Organometallverbindung des Rutheniums Ruthenocen ist.

11. Verfahren nach Anspruch 9 oder 10, dadurch gekennzeichnet, daß das Trägergas ein Inertgas oder eine Mischung aus Inertgas und Wasserstoff ist.

12. Verfahren nach einem der Ansprüche 9 bis 11, dadurch gekennzeichnet, daß das Substrat ein Einkristall ist, der auf eine Temperatur von etwa 200 bis etwa 650°C erwärmt wird.

13. Verfahren nach einem der Ansprüche 9 bis 11, dadurch gekennzeichnet, daß das Substrat ein Glas ist, das auf eine Temperatur von etwa 450 bis etwa 900°C erwärmt wird.

14. Verwendung einer Dünnschicht nach einem der Ansprüche 1 bis 8 zur Herstellung von Halbleiteranordnungen oder -bauteilen, von Photoelektroden oder Katalysatoren oder als Schutzüberzug.

**Claims**

1. A thin layer deposited on a solid substrate, characterized by the fact that the said thin layer consists essentially of a compound of formula $RuX_{2\pm x}Z_y$ in which X represents at least one element chosen from sulphur, selenium and tellurium, x is a number less than or equal to 0.02 representing the deviation from stoichiometry, Z is a doping agent which is introduced should the occasion arise, and y is the number of atoms of doping agent per atom of ruthenium.

2. A thin layer as in Claim 1, characterized by the fact that the said doping agent is present at the rate of $10^{-2}$ to $10^{-8}$ atoms per atom of ruthenium.

3. A thin layer as in either of the preceding claims, characterized by the fact that the said substrate is an insulator and in particular a glass such as a silica glass.

4. A thin layer as in either of the Claims 1 or 2, characterized by the fact that the said substrate is a semiconductor.

5. A thin layer as in either of the Claims 1 or 2, characterized by the fact that the said substrate is a conductor, in particular a metal.

6. A thin layer as in any one of the preceding claims, characterized by the fact that the said thin layer consists of ruthenium sulphide.

7. A thin layer as in any one of the Claims 1, 2 and 4 to 6, characterized by the fact that the said substrate is a crystal having lattice parameters in harmony with those of the crystal $RuX_2$, and that the said thin layer is a monocrystalline layer obtained by epitaxial growth.

8. A thin layer as in Claim 7, characterized by the fact that the said substrate is a crystal of gallium arsenide.

9. A method of preparation of a thin layer as defined in any one of the preceding claims, mainly characterized by the fact that the substrate (3) is brought up to a temperature of about 200 to 1000°C, that by means of a flow of vector gas (A, C) a mixture of vapours of an organometallic compound of ruthenium (6) and of vapours (D) of a compound $XH_2$, X being defined as previously, is brought into the vicinity of the substrate, the deliveries of the reactive gases being regulated so as to correspond with the respective proportions of the elements Ru and X in the compound which it is wished to obtain in the form of a thin layer deposited on the substrate, and that in addition a doping agent is if desired introduced in accordance with known methods into the said thin layer.

10. A method as in Claim 9, characterized by the fact that the organo-metallic compound of ruthenium is ruthenocene.

11. A method as in Claim 9 or 10, characterized by the fact that the said vector gas is an inert gas or a mixture of inert gas and hydrogen.

12. A method as in any one of the Claims 9 to 11, characterized by the fact that the said substrate is a monocrystal and that it is heated to a temperature of about 200 to 650°C.

13. A method as in any one of the Claims 9 to 11, characterized by the fact that the said substrate is a glass and that it is heated to a temperature of about 450 to 900°C.

14. Utilization of a thin layer as defined in any one of the Claims 1 to 8, in the realization of semiconductor assemblies or components or of photoelectrodes or catalysts, or as a protective coating.